Europäisches Patentamt

European Patent Office

Office européen des brevets

(19)

(11) Veröffentlichungsnummer: **0 411 594 A2**

# EUROPÄISCHE PATENTANMELDUNG

(12)

(21) Anmeldenummer: 90114729.8

(51) Int. Cl.⁵: **G06F 11/24**, G01R 31/28

(22) Anmeldetag: 31.07.90

(30) Priorität: 31.07.89 DE 3925339

(43) Veröffentlichungstag der Anmeldung:
06.02.91 Patentblatt 91/06

(84) Benannte Vertragsstaaten:
DE FR GB IT NL

(71) Anmelder: **Siemens Aktiengesellschaft**
**Wittelsbacherplatz 2**
**D-8000 München 2(DE)**

(72) Erfinder: **Barre, Claude, Dipl.-Ing.**
**Implerstrasse 23**
**D-8000 München 70(DE)**

(54) **Schaltungsanordnung und Verfahren zur Funktionssicherheitsprüfung für integrierte Halbleiterspeicher.**

(57) Um digitale Halbleiterspeicher, die aus einer Vielzahl von zeilen- und spaltenweise angeordneten Speicherzellen (S1,...,S4) bestehen, auf ihre Funktionssicherheit prüfen zu können, wird vorgeschlagen, im Halbleiterspeicher voneinander elektrisch getrennte Spannungsversorgungsleitungen (SV1,SV2) für die Speicherzellen (S1,...,S4) und für die Treiberstufen (TS) der Auswahlleitungen (AL) (Wortleitungen) vorzusehen. Ein positiver bzw. negativer Differenzwert zwischen den Spannungen auf den Spannungsversorgungsleitungen (SV1,SV2) vergrößert bzw. verkleinert gezielt den Durchgangswiderstand der die Speicherzellen zum Lesen oder Schreiben an Datenleitungen (DL,DR) ankoppelnden Tortransistoren (TL,TR).

# SCHALTUNGSANORDNUNG UND VERFAHREN ZUR FUNKTIONSSICHERHEITSPRÜFUNG FÜR INTEGRIERTE HALBLEITERSPEICHER

Die Erfindung betrifft eine Schaltungsanordnung und ein Verfahren zur Funktionssicherheitsprüfung von integrierten Halbleiterspeichern nach den Oberbegriffen der Patentansprüche 1 bzw. 6.

Integrierte Halbleiterspeicher werden als digitale Bauelemente vor allem in Anlagen der Datenverarbeitungstechnik verwendet. Die durch ständige Weiterentwicklung erzielte Speicherkapazität bei diesen Halbleiterspeichern trägt entscheidend dazu bei, daß ihnen als Speichermedium eine ständig größer werdende Bedeutung zukommt.

Da jeder Speicherbaustein für sich eine auf einem Halbleiterplättchen integrierte hoch komplexe Schaltung mit einer Vielzahl von aktiven und passiven Elementen darstellt, können bereits geringste Toleranzen bei der Fertigung solcher Halbleiterspeicher zu fehlerhaften Bausteinen führen. Um möglichst sicher zu sein, daß keine fehlerhaften Bausteine die Fertigung verlassen, werden die gefertigten Bausteine einzeln auf ihre Funktionsfähigkeit hin überprüft.

Eine solche Funktionsprüfung wird in der Regel zum ersten Mal dann durchgeführt, wenn der Halbleiterspeicher noch als Halbleiterplättchen vorliegt und noch nicht in ein Gehäuse eingesetzt ist. Nur diejenigen Speicherbausteine bestehen die Funktionsprüfung, bei denen sich jede Speicherzelle unabhängig von allen anderen mit beiden digitalen Informationswerten beschreiben läßt und ein jeweiliger Informationswert beim Auslesen der Speicherzelle erhalten bleibt.

Dadurch wird zwar im allgemeinen die Funktionsfähigkeit der Speicherbausteine nachgewiesen, Bausteine mit einer durch Technologieschwächen bedingten verminderten Funktionssicherheit werden bei einer solchen Bausteinprüfung jedoch meistens nicht erkannt, weil die Funktionsprüfungen nicht unter sogenannten "worst case"-Bedingungen, wie sie im Einsatzfall auftreten, durchgeführt werden.

Aus der DE-OS 21 06 163 ist es bereits bekannt, bei einem Funktionstest die Versorgungsspannung eines Prüflings im Grenzbereich der zugelassenen Werte zu verändern.

Weiterhin ist es aus der DE-OS 30 40 733 bekannt, zur Untersuchung von integrierten Schaltungsanordnungen, insbesondere von Speicherbausteinen, Schaltungsteile mit ohnehin geringer Störsicherheit zur weiteren Verminderung der Störsicherung einer radioaktiven Alpha-Strahlung auszusetzen und das dadurch ausgelöste Fehlverhalten zu beobachten. Das bekannte Verfahren ist jedoch aufwendig und daher vorteilhaft nur in der Entwicklungsphase, beispielsweise zur Untersuchung erster Fertigungsmuster anwendbar.

Der Erfindung liegt daher die Aufgabe zugrunde, eine Schaltungsanordnung für integrierte Halbleiterspeicher anzugeben, die auf unkomplizierte Weise eine Prüfung der Funktionssicherheit eines betreffenden Halbleiterspeichers erlaubt, und ein Verfahren vorzuschLagen, das eine Prüfung der Funktionssicherheit mit geringem technischem Aufwand ermöglicht.

Gelöst wird diese Aufgabe erfindungsgemäß durch die im Anspruch 1 bzw. 6 angegebenen Merkmale.

Ein wesentlicher Vorteil der Erfindung besteht darin, daß eine Aufteilung der Versorgungsleitungen relativ einfach zu realisieren ist und dabei keine zusätzlichen Bauelemente zu integrieren sind.

Vorteilhafte Ausgestaltungen sowie vorteilhafte Anwendungsmöglichkeiten sind in den Unteransprüchen 2 und 3 bzw. 4 und 5 angegeben. Mit dem erfindungsgemäßen Verfahren nach Anspruch 6 läßt sich jeder Baustein im Hinblick auf seine Störsicherheit und damit seine Funktionssicherheit bewerten, womit auch eine Sortierung der Bausteine in Qualitätsklassen realisierbar wäre.

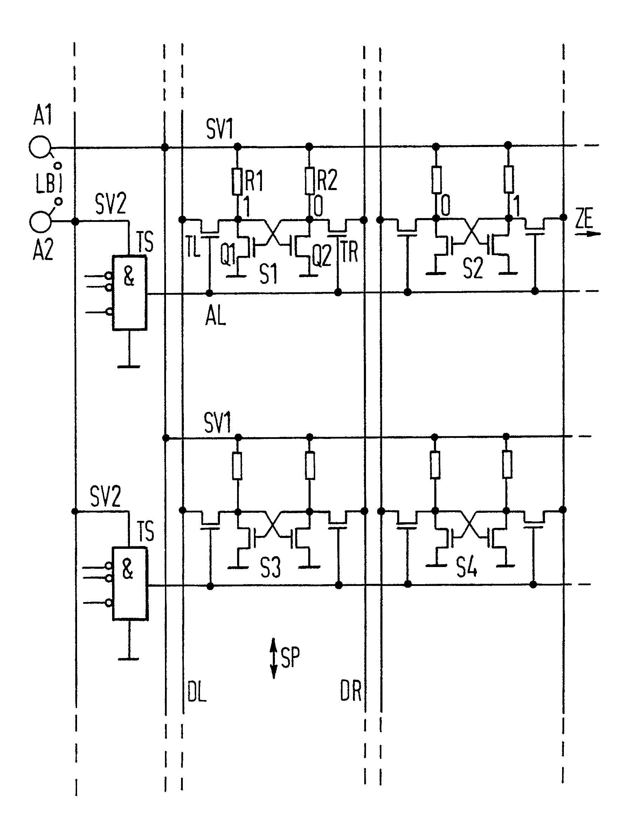

Ein Ausführungsbeispiel der Erfindung wird im folgenden anhand der Zeichnung näher erläutert.

Dabei zeigt die FIG einen Ausschnitt aus einem Stromlaufplan für einen integrierten statischen Schreib-/Lesespeicher in MOS-Technologie.

Dieser Ausschnitt, auf dem die zueinander identischen Schaltbilder von vier Speicherzellen S1,...,S4 dargestellt sind, soll die prinzipielle schaltungstechnische Anordnung der Speicherzellen in Form von Zeilen und Spalten innerhalb eines Halbleiterspeichers deutlich machen.

Jede Speicherzelle S1,...,S4 ist als gewöhnliche Flip-Flop-Schaltung zur Speicherung von binären Informationswerten realisiert und besteht aus zwei als Feldeffekttransistoren ausgebildeten Invertertransistoren Q1, Q2. Diese Invertertransistoren Q1, Q2 weisen jeweils einen mit einem Massepotential verbundenen ersten Schaltstreckenanschluß und jeweils einen über jeweilige Lastwiderstände R1, R2 mit einer ersten Spannungsversorgungsleitung SV1 verbundenen zweiten Schaltstreckenanschluß auf. Diese zur Spannungsversorgung aller Speicherzellen vorgesehene erste Spannungsversorgungsleitung SVI ist auf eine erste Anschlußstelle A1 aus der Schaltung herausgeführt. Erwähnenswert ist, daß bei in CMOS-Logik realisierten Halbleiterspeichern die Lastwiderstände R1, R2 durch zu den Invertertransistoren Q1, Q2 komplementär ausgebildete MOS-Feldeffekttransistoren ersetzt sind.

Im Sinne einer Kreuzkopplung zwischen den beiden Invertertransistoren Q1, Q2 ist ihr jeweiliger zweiter Schaltstreckenanschluß auf den Steueranschluß des jeweilig anderen Invertertransistors geführt.

Für jede Spalte SP des Speichers stehen jeweils zwei Datenleitungen DL, DR zur Verfügung, mit denen sämtliche Speicherzellen S1, S3 der betreffenden Spalte über Tortransistoren TL, TR verbunden sind. Für jede Speicherzelle S1,...,S4 sind dazu zwei Tortransistoren TL, TR vorgesehen, die jeweils einer Datenleitung DL, DR zugeordnet sind, und die mit ihrer Schaltstrecke den zweiten Schaltstreckenanschluß eines jeweiligen Invertertransistors Q1, Q2 mit der zugeordneten Datenleitung DL, DR verbinden.

Jeder Zeile ZE des Speichers ist eine Treiberstufe TS in Form einer Adreßauswahleinrichtung zugeordnet, die ausgangsseitig an eine der Zeile zugeordneten Auswahlleitung AL angeschlossen ist. Diese Auswahlleitung AL ist mit den Steuerelektroden der in der betreffenden Zeile ZE des Speichers befindlichen Tortransistoren TL, TR verbunden. Die Treiberstufen TS sind zur Spannungsversorgung an eine, von der ersten Spannungsversorgungsleitung SV1 elektrisch getrennte zweite Spannungsversorgungsleitung SV2 angeschlossen, die an einer zweiten Anschlußstelle A2 aus der Schaltung herausgeführt ist.

Damit gezielt eine Speicherzelle ausgelesen bzw. ein Informationswert eingeschrieben werden kann, muß eine Adressenvorgabe an den Treiberstufen TS dazu führen, daß die Auswahlleitungen AL derjenigen Zeile ZE, in der sich die angesprochene Speicherzelle befindet, einen elektrischen H-Pegel aufweist.

Eine weitere Adressenvorgabe ist im übrigen noch dazu vorgesehen, um genau die Spalte SP auszuwerten, in der sich die angesprochene Speicherzelle befindet.

Bei einem elektrischen H-Pegel auf der Auswahlleitung AL werden die Tortransistoren TL, TR der betreffenden Zeile ZE leitend. Daraufhin werden beide Datenleitungen DL, DR einer jeden Spalte über die Tortransistoren TL, TR mit zueinander komplementären elektrischen Pegeln d.h. einem elektrischen L- und H-Pegel beaufschlagt, wobei es vom in der Speicherzelle gespeicherten Informationswert abhängig ist, welche Datenleitungen DL, DR einen H- bzw. L-Pegel aufweist.

Durch einen Meßvorgang auf den beiden relevanten Datenleitungen DL, DR kann damit der Inhalt der Speicherzelle ermittelt, also ausgelesen werden. Dazu dient eine Schreib-Lese-Verstärkereinrichtung (nicht dargestellt), die zum Einschreiben eines Informationswertes die Datenleitungen DL, DR mit entsprechend komplementären Pegeln beaufschlagt, wodurch ein Umschalten der Speicherzelle, falls diese bisher einen anderen Informationswert gespeichert hatte, erfolgt. Die Schreib-Lese-Verstärkereinrichtung ist an die Spannungsversorgungsleitung SV1 der Speicherzellen angeschlossen.

Um diese Funktionen zu ermöglichen, sind die Tortransistoren TL, TR gegenüber den Invertertransistoren Q1, Q2 im Hinblick auf ihren Ohm'schen Widerstand im leitenden Zustand so bemessen, daß der Widerstand der Tortransistoren TL, TR einerseits nicht zu klein ist, weil dann ein Auslesen der Speicherzelle zu einer Änderung ihres Inhaltes führen kann und andererseits der Widerstand der Tortransistoren TL, TR nicht zu groß ist, weil dadurch ein Beschreiben der Speicherzelle nicht mehr möglich ist.

Bei einer Fertigung hochintegrierter Speicherbausteine kann eine kritische Dimensionierung dieser Art gewissen Schwankungen unterworfen sein, die u.U. dazu führen können, daß Bausteine bei einer herkömmlichen Funktionsprüfung gerade noch funktionieren d.h. daß sich bei extremeren Bedingungen, wie sie im Einsatzfall vorkommen, Fehlfunktionen einstellen können.

Mit voneinander elektrisch getrennten Spannungsversorgungsleitungen für die Speicherzellen S1,...,S4 und die Treiberschaltungen TS kann nun festgestellt werden, ob bei einem jeweiligen Speicherbaustein die Abweichung von der gewollten Dimensionierung zu groß ist. Dazu werden bei einer Funktionsprüfung des jeweiligen Speicherbausteins, der noch in Form eines Halbleiterplättchens vorliegt, die Anschlußflächen A1, A2 zunächst mit annähernd gleichen Spannungspotentialen z.B. + 5 Volt beaufschlagt. Dann wird das Spannungspotential an der zur Versorgung der Treiberschaltung TS vorgesehenen zweiten Anschlußfläche A2 um einen Differenzwert erhöht, wodurch auch der elektrische H-Pegel auf den Auswahlleitungen AL ansteigt, und an den Steuereingängen der Tortransistoren TL, TR ein höheres Spannungspotential anliegt, was wiederum den Ohm'schen Widerstand der Schaltstrecke der Tortransistoren TL, TR verringert. Stellt sich unter dieser Bedingung kein Speicherfehler ein, wird anschließend das Spannungspotential auf der zweiten Anschlußfläche A2 gegenüber dem auf der ersten Anschlußfläche A1 um den gleichen Differenzwert verringert.

Ein Verringern der Versorgungsspannung für die Treiberschaltungen TS führt zu einer Erhöhung des Ohm'schen Widerstandes bei den Tortransistoren TL, TR.

Falls in beiden Fällen kein Speicherfehler auftritt, wird der betreffende Speicherbaustein als störsicher d.h. als stabil erklärt, und das betreffende Halbleiterplättchen in ein Gehäuse eingesetzt. Die beiden am Randbereich des Halbleiterplättchens befindlichen Anschlußflächen A1, A2 können zuvor über eine Leitungsbrücke LB miteinander verbunden werden, so daß für den weiteren Gebrauch des Speicherbausteins nur noch eine Spannungszufuhr nötig ist.

Die Anschlußflächen A1, A2 können aber auch mit jeweils einem Gehäuseanschluß (nicht dargestellt) verbunden werden, wodurch der Halbleiterspeicher auch im eingebauten Zustand erfindungsgemäß prüfbar ist.

aufschlagt werden, daß ein jeweiliger Halbleiterspeicher nur dann als stabil bewertet wird, wenn sowohl in einem ersten Prüfzustand, bei dem eine der Betriebsspannungen gegenüber der jeweiligen anderen um einen Differenzwert in eine erste Richtung verändert wird, als auch in einem zweiten Prüfzustand, bei dem die Betriebsspannung um den Differenzwert in eine entgegengesetzte Richtung verändert wird, ein fehlerfreies Auslesen und Einschreiben von Informationswerten möglich ist.

## Ansprüche

1. Schaltungsanordnung zur Funktionssicherheitsprüfung für einen auf einem Halbleiterplättchen integrierten digitalen Speicher mit einer Vielzahl von Speicherzellen (S1,...,S4) für je einen binären Informationswert, mit Datenleitungen (DL, DR) zum Auslesen und Einschreiben von Informationswerten, mit den Speicherzellen (S1,...,S4) zugeordneten Tortransistoren (TL, TR) zum selektiven Freigeben eines Datenweges zwischen einer jeweiligen Speicherzelle und einer Datenleitung (DL, DR), mit Auswahlleitungen (AL) zum gezielten Ansteuern der Tortransistoren (TL, TR) sowie mit Treiberstufen (TS) für die Auswahlleitungen (AL) zur Ausgabe von ein Schließen bzw. Öffnen der Tortransistoren (TL, TR) bewirkenden Spannungspegeln, **dadurch gekennzeichnet,** daß die Speicherzellen (S1...S4) und die Treiberstufen (TS) voneinander elektrisch getrennte Spannungsversorgungsleitungen (SV1, SV2) aufweisen.

2. Schaltungsanordnung nach Anspruch 1, **dadurch gekennzeichnet,** daß die Spannungsversorgungsleitungen (SV1,SV2) an Anschlußstellen (A1,A2) über eine Leitungsbrücke (LB) miteinander verbindbar sind.

3. Schaltungsanordnung nach Anspruch 2, **dadurch gekennzeichnet,** daß die Anschlußstellen (A1, A2) im Randbereich des Halbleiterplättchens angeordnet sind.

4. Schaltungsanordnung nach einem der Ansprüche 1 bis 3, **gekennzeichnet durch** eine Verwendung für in CMOS-Technologie realisierte Schreib-/Lesespeicher.

5. Schaltungsanordnung nach einem der Ansprüche 1 bis 3, **gekennzeichnet durch** eine Verwendung für in BICMOS-Technologie realisierte Schreib-/Lesespeicher.

6. Verfahren zur Funktionssicherheitsprüfung bei integrierten Halbleiterspeichern unter Verwendung einer Schaltungsanordnung nach einem der Ansprüche 1 bis 5, **dadurch gekennzeichnet,** daß die Spannungsversorgungsleitungen (SV1,SV2) mit voneinander unabhängig veränderbaren Betriebsspannungen be-